# EUROPÄISCHE PATENTANMELDUNG

(11) **EP 0 650 315 A2**
(43) Veröffentlichungstag der Anmeldung: **26.04.1995**
(21) Anmeldenummer: 94116528.4
(22) Anmeldetag: 20.10.1994
(51) Int. Cl.: H05K 5/06, H05K 3/28

(54) **Elektrisches Steuergerät, insbesondere zum Einbau in Kraftfahrzeuge**

(30) Priorität: 23.10.1993 DE 9316235 U
(71) Anmelder: Leonische Drahtwerke AG, D-90402 Nürnberg (DE)
(72) Erfinder: Reichinger, Gerhard, D-91126 Rednitzhembach (DE)
(74) Vertreter: Tergau, Enno, Dipl.-Ing.

(57) **Zusammenfassung**

Die Erfindung betrifft ein elektrisches Steuergerät 1, insbesondere zum Einbau in Kraftfahrzeuge. Es enthält eine Leiterplatte 4 mit elektronischen Bauteilen. Die Leiterplatte ist zumindest auf ihrer Bestückungsseite 5 mit insgesamt wenigstens drei Schichten aus dem gleichen Kunststoffmaterial abgedeckt, wobei das Material der einzelnen Schichten unterschiedliche mechanische Eigenschaften aufweist. Die erste Schicht bildet eine Grundisolierung 8. An diese Grundisolierung schließt sich eine Stützschicht 11 an. Als Außenschicht 12 ist schließlich eine weitere Schicht vorgesehen, die eine höhere Festigkeit aufweist als die beiden vorgenannten Schichten.

## Beschreibung

Die Erfindung betrifft ein elektrisches Steuergerät, insbesondere für Kraftfahrzeuge. Im Zuge fortschreitender Technisierung werden in zunehmendem Maße komplexe Steuerungs- und Regeleinheiten zu integrierten Bauteilen zusammengefaßt. Ein Beispiel hierfür sind Mikrocomputer zur Steuerung und Überwachung von Fahrzeugfunktionen. Derartige Steuergeräte, zu denen im weiteren Sinn auch Geräte der Unterhaltungselektronik, beispielsweise Einbau-Radiogeräte zu zählen sind, sind üblicherweise von einem starren, meist aus Blech bestehenden Gehäuse umgeben. Darin ist wenigstens eine Leiterplatte mit elektrischem und/oder elektronischen Bauteilen angeordnet und mit Befestigungselementen, wie Schrauben oder Schnappverbindungen, am Gehäuse fixiert.

Aus DE 42 37 870 A1 sind elektrische Steuergeräte bekannt, bei denen das Gehäuse durch einen Kunststoffschaumkörper ersetzt ist, in den die Leiterplatte samt ihren elektronischen Bauteilen eingebettet ist. Bei den bekannten Steuergeräten ist die Leiterplatte samt ihren elektronischen Bauteilen mit einem Tauchlacküberzug als Feuchtigkeitssperre versehen. Solche Lacküberzüge haben den Nachteil, daß sie relativ toxisch und daher und aufgrund ihres Lösungsmittelgehaltes aus gesundheitlichen Gründen umstritten sind. Sie werden deshalb vielfach durch Silikonüberzüge ersetzt. Silikon hat aber den Nachteil, daß es relativ teuer ist. Außerdem läßt sich der Silikonüberzug nur mit relativ hohem fertigungstechnischen Aufwand herstellen. Ein weiterer Nachteil der bekannten Steuergeräte besteht darin, daß aufgrund der zu ihrer Herstellung verwendeten unterschiedlichen Materialien eine Wiederverwertung kaum möglich ist. Eine Möglichkeit, nicht mehr zu brauchende Steuergeräte für eine Wiederverwertung aufzuarbeiten, bestünde darin, das Gerät durch einen Schreddervorgang zu zerkleinern und die so entstandenen Partikel unterschiedlicher Dichte etwa durch eine Windsichtung zu trennen. Auf diese Art und Weise läßt sich das Material in eine Kunststoff und in eine Elektronikschrott-Fraktion trennen. Bei dem aus DE 42 37 870 A1 bekannten elektrischen Bauteil würde der Tauchlacküberzug das Kunststoffmaterial des die bisherigen Gehäuseschalen ersetzenden Formschaumkörpers verunreinigen. Gleiches wäre der Fall, wenn statt eines Tauchlacküberzugs ein Silikonüberzug vorhanden ist. Auch in diesem Fall würde das Silikon zu einer die chemischen und physikalischen Eigenschaften des ursprünglichen Materials verändernden Verunreinigung führen.

Ein weiterer Nachteil von elektrischen Steuergeräten, bei denen das Gehäuse durch einen Schaumkörper ersetzt ist, besteht darin, daß diesen Schaumkörpern eine feste Ummantelung fehlt, die die empfindlichen elektronischen Bauteile vor mechanischen Einflüssen schützt. Ein Kunststoffschaumkörper kann beispielsweise im Reparaturfalle eines Kraftfahrzeugs leicht ungewollt mit einem spitzen Gegenstand, etwa einem Schraubenzieher, durchbohrt und die sich darin befindlichen elektronischen Bauteile beschädigt werden. In einem solchen Fall müßte das gesamte Bauteil unter erheblichem Kostenaufwand erneuert werden. Schließlich ist noch von Nachteil, daß zur Befestigung eines solchen Schaumkörpers, beispielsweise an einer Kraftfahrzeugkarosserie, besondere Befestigungsteile und -maßnahmen notwendig sind. Das elektrische Gerät müßte etwa durch Befestigungsbügel oder Befestigungsbänder an der Fahrzeugkarosserie befestigt werden.

Es ist daher Aufgabe der Erfindung, ein elektrisches Steuergerät vorzusehen, das die Nachteile des Standes der Technik nicht aufweist. Zielsetzung ist es, die bisherigen, aus Metall oder aus Kunststoff bestehenden Gehäuse zu ersetzen, ohne dabei im Hinblick auf den mechanischen Schutz, die Feuchtigkeitsabdichtung und die Montagefreundlichkeit Einbußen hinnehmen zu müssen. Die der Erfindung zugrundeliegende übergeordnete Aufgabe besteht dabei darin, daß das neu geschaffene Steuergerät unter technisch und ökonomisch vertretbarem Aufwand einem stofflichen Wiederverwertungskreislauf zuführbar ist.

Diese Aufgabe wird durch die Merkmalskombination des Anspruches 1 gelöst. Die die elektronischen Bauelemente tragende Leiterplatte des Steuergeräts ist vollständig in einem Kunststoffkörper eingebettet, der einen dreischichtigen Aufbau aufweist. Die erste Schicht bildet eine Grundisolierung, die die Leiterplatte und die sich darauf befindlichen elektronischen und/oder elektrischen Elemente im Sinne einer Feuchtigkeitssperre abdichtet. Diese Grundisolierung kann bei entsprechender Auswahl des Materials auch als elektrische Isolierung dienen. Im Gegensatz zu einer Tauchlackschicht kann die aus dem Kunststoffmaterial bestehende Grundisolierung noch eine weitere Funktion übernehmen, nämlich eine Stützfunktion für die elektronischen Bauelemente nach Art eines Außenskeletts. Dies umsomehr, wenn die Schichtdicke der Grundisolierung entsprechend groß ist. Parallel zur Planfläche der Leiterplatte wirkende Beschleunigungskräfte, etwa im Falle von hohen negativen Beschleunigungen beim Abbremsen von Kraftfahrzeugen oder bei den von vielen Automobilherstellern mit Steuergeräten durchgeführten Falltests und Vibrationen können dadurch abgefangen bzw. gedämpft werden. In dieser Grundisolierung sind die Befestigungsfüßchen der elektronischen Bauelemente eingebettet und dadurch ebenfalls nach Art eines Korsetts zusätzlich stabilisiert.

An die Grundisolierung schließt sich als zweite Schicht eine Stützschicht an, die zumindest den bestückten und mit der Grundisolierung versehenen Bereich der Leiterplatte abdeckt und dabei die elektronischen Bauelemente vollständig in sich einschließt. Diese Stützschicht dient zur Stützung der elektronischen Bauelemente und wirkt wie eine Polsterung, die die gesamte elektronische Baugruppe vor mechanischen Einwirkungen, etwa negativen Beschleunigungskräften, schützt. Sie wirkt darüber hinaus, wie auch in gewissem Maße die Grundisolierung, als Wärmeisolator. Eine solche Wärmeisolation kann beispielsweise von Bedeutung sein, wenn ein Steuergerät in nächster Nähe eines Kraftfahrzeugmotors montiert werden muß. Die Stützschicht bildet außerdem eine weitere Barriere gegen den Zutritt von Feuchtigkeit und sonstigen Einflüssen, wie etwa aggressiven Gasen.

Als dritte Schicht schließt sich an die Stützschicht eine Außenschicht an, die zumindest den von der Stützschicht überdeckten Bereich der Leiterplatte nach Art einer Gehäuseschale oder eines Gehäusedeckels abschließt. Sie weist eine höhere Festigkeit auf als die Grundisolierung und die Stützschicht. Sie kann daher beispielsweise mit Gewindebohrungen zur Befestigung an einer Kraftfahrzeugkarosserie versehen werden. Denkbar ist auch, daß an die Außenschicht Befestigungsaugen oder -laschen angeformt sind.

Vorteilhaft ist es, wenn das Material für die genannten Schichten in Form einer aus zwei unter Aushärtung miteinander reagierenden flüssigen Komponenten bei Raumtemperatur auf der Leiterplatte ausgebracht ist. Ein solches Material ist beispielsweise, wie in Anspruch 3 angegeben, zweikomponentiges, nämlich wenigstens ein Polyol und Isocianat bestehendes Polyurethan. Bei Materialien, die bei relativ hohen Temperaturen auf die Leiterplatte aufgebracht werden, beispielsweise Gießharze, haben den Nachteil, daß durch die Berührung des heißen Materials mit der Umgebungstemperatur aufweisenden Oberfläche sowohl der elektronischen Bauelemente als auch der Leiterplatte ein Abschreckeffekt auftritt, der unter Umständen eine intensive stoffschlüssige Verbindung zwischen dem aufgebrachten Material und den genannten Oberflächen verhindert. Auf diese Weise entstehen zwischen dem aufgebrachten Material und den genannten Oberflächen Zwischenräume, die den Zutritt von Feuchtigkeit erlauben.

Gemäß den Ansprüchen 4 und 5 besteht sowohl die Außenschicht als auch die Grundisolierung und die Stützschicht aus einem Vollmaterial. Den Ausgangskomponenten des Kunststoffmaterials ist also kein Schaumbildner beigefügt. Je nach Anforderung an die mechanische Stützfähigkeit und die Wärmeisolationsfähigkeit der Stützschicht kann diese wahlweise auch aus einem Schaummaterial bestehen. Ein Schaummaterial wäre etwa auch dann zweckmäßig einzusetzen, wenn Gewicht eingespart werden soll. Nach Anspruch 7 ist die Grundisolierung auch auf der Rückseite der Leiterplatte angeordnet, d.h. also auf der nicht Bauteilen bestückten Lötseite der Leiterplatte. Auf dieser Seite stehen die Befestigungsfüßchen heraus und sind mit einem Lötkegel an der Leiterplatte befestigt. Ein etwa die Bildung von Korrosion oder Kriechströmen fördernder Zutritt von Feuchtigkeit kann durch die Anordnung der Grundisolierung auch auf der Lötseite der Leiterplatte wirksam verhindert werden.

In Anspruch 8 ist eine Ausführungsform der Erfindung angegeben, bei der die Leiterplatte in einer herkömmlichen Gehäuseschale angeordnet und dort auf herkömmlche Weise befestigt ist. Der die Leiterplatte umgebende Innenraum der Gehäuseschale ist mit einer Stützschicht unter vorzugweise vollständigem Einschluß der Leiterplatte und ihrer elektrischen Bauteile ausgefüllt. Die Leiterplatte ist mit einer Grundisolierung abgedeckt. Die Außenschicht ist dabei vorzugsweise so angeordnet, daß sie die Öffnung der Gehäuseschale vollständig überdeckt. Der bei herkömmlichen Gehäuseschalen notwendige Deckel und die konstruktive Maßnahme zur Abdichtung zwischen Deckel und Gehäuse können dadurch entfallen. Vorteilhaft ist insbesonders, daß die Bereitstellung von Deckeln unterschiedlicher Größe für unterschiedlich bemessene Gehäuseschalen entfallen kann. Die Gehäuse können, ohne die bisherige Produktionsweise umzustellen, vorgefertigt und mit Leiterplatten bestückt werden. Anstelle der bisherigen Deckelmontage wird der Gehäuseinnenraum mit der Stütz- und Außenschicht ausgefüllt. Vorzugsweise bestehen die Gehäuseschalen aus dem gleichen Material wie die genannten Schichten.

Wenn, wie in Anspruch 10 angegeben, die Außenschicht den Öffnungsrand der Gehäuseschale zumindest teilweise überdeckt und mit dem Öffnungsrand stoffschlüssig verbunden ist, ist eine zusätzliche Abkapselung des Geräteinneren und eine weitere mechanische Stabilisierung erreicht. Es ist nämlich denkbar, daß während der Lebensdauer des Steuergeräts, etwa unterstützt durch chemische Einflüsse, die Stützschicht schwindet. Dadurch würde zwischen der Gehäuseschalen-Innenwand und der Stützschicht ein Spalt entstehen, durch den Feuchtigkeit oder auch Gase eindringen könnten. Dadurch, daß die Außenschicht mit dem Öffnungsrand der Gehäuseschale stoffschlüssig verbunden ist, ist dies wirkungsvoll verhindert.

Bei herkömmlichen Gehäuseschalen ist auf dem Öffnungsrand eine Nut zur Aufnahme eines Dichtringes angeordnet. Dieser Dichtring hat die Aufgabe, die Trennfuge zwischen Deckel und Öffnungsrand abzudichten. Wenn also solche herkömmlichen Gehäuseschalen verwendet werden, kann die Nut dazu dienen, zusätzlich zur stoffschlüssigen Verbindung zwischen Außenschicht und Öffnungsrand eine Formschlußverbindung herzustellen. Die Festigkeit der Verbindung zwischen Außenschicht und Gehäuseschale ist dadurch erhöht. Dies kann insbesondere dann von Bedeutung sein, wenn sich die Gehäuseschale und/oder die Außenschicht infolge etwa länger dauernder Temperatureinwirkung oder durch chemische- und Umwelteinflüsse verzieht. Die durch die genannte Maßnahme hervorgerufene festere Verbindung zwischen der Außenschicht und der Gehäuseschale verhindert in weitaus höherem Maße, als dies nur durch eine Stoffschlußverbindung möglich wäre, das Ablösen der Außenschicht vom Öffnungsrand der Gehäuseschale.

Nach Anspruch 12 ist die Leiterplatte des Steuergerätes mit ihrer Grundisolierung vollständig von der Stützschicht umgeben und darin eingebettet. Die Stützschicht ihrerseits ist praktisch vollständig von der Außenschicht nach Art eines Gehäuses umgeben. Diese Ausgestaltung eines erfindungsgemäßen Steuergerätes ist besonders vorteilhaft, weil dadurch einerseits die Fertigung wesentlich vereinfacht ist und andererseits die Wiederverwertung erleichtert ist, da außer dem Leiterplatten- und dem Material der elektronischen Bauteile nur noch ein weiteres Material, nämlich das Kunststoffmaterial, vorhanden ist. Eine vorteilhafte Ausgestaltung des erfindungsgemäßen Steuergeräts ist in Anspruch 13 angegeben. Um das Steuergerät mit einem Anschlußkabel zu verbinden, muß es ein entsprechendes Verbindungselement, einen Stecker oder eine Buchse aufweisen. Es wäre nun denkbar, ein solches, auf herkömmliche Weise hergestelltes Verbindungselement an der Außenschicht zu befestigen. Dies wäre allerdings mit einem zusätzlichen Montageaufwand verbunden. Außerdem müßte das Verbindungselement u.U. vor der Wiederverwertung des Steuergeräts wieder abmontiert werden. Diese Nachteile sind dadurch umgangen, daß ein entsprechendes Verbindungselement an die Außenschicht angeformt ist. Fertigungstechnisch bedeutet dies, daß nur einmal bei der Formherstellung ein zusätzlicher Aufwand erforderlich ist.

Weiterhin besteht das Problem, die in dem an der Außenschicht angeordneten Verbindungselement vorhandenen Kontaktelemente mit der im Inneren des Steuergeräts angeordneten Leiterplatte zu verbinden. Gemäß Anspruch 14 wird dies vorteilhaft dadurch gelöst, daß die Leiterplatte durch die Außenschicht hindurch mit einem Kontaktbereich in das Gehäuse des an der Außenschicht angeformten Verbindungselements hineinragt. Der Kontaktbereich ist dabei mit der innerhalb der Außenschicht angeordneten Leiterplatte über Leiterbahnen verbunden.

Die Erfindung wird nun anhand der in den Zeichnungen dargestellten Ausführungsbeispiele näher erläutert. Es zeigen:
- Fig.1: ein erfindungsgemäßes elektronisches Steuergerät im Querschnitt,
- Fig.2: ein Steuergerät gemäß Fig.1 mit modifizierter Grundisolierung,
- Fig.3: eine die Kontaktierung eines erfindungsgemäßen Steuergeräts mit einem Anschlußkabel zeigende Darstellung,
- Fig.4: ein Steuergerät gemäß Fig.3 mit einer modifizierten Kontaktierung,
- Fig.5: eine weitere Ausführungsform eines erfindungsgemäßen Steuergeräts, bei dem die Leiterplatte in einer Gehäuseschale angeordnet ist,
- Fig.6: einen Querschnitt längs der Linie VI-VI in Fig.5, und
- Fig.7: ein Steuergerät gemäß Fig.5, komplettiert durch eine Außenschicht.

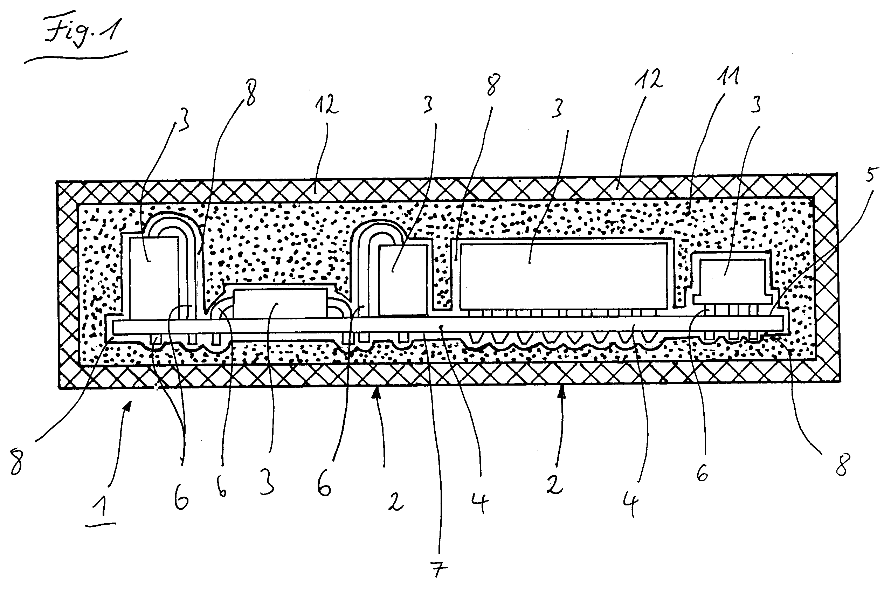

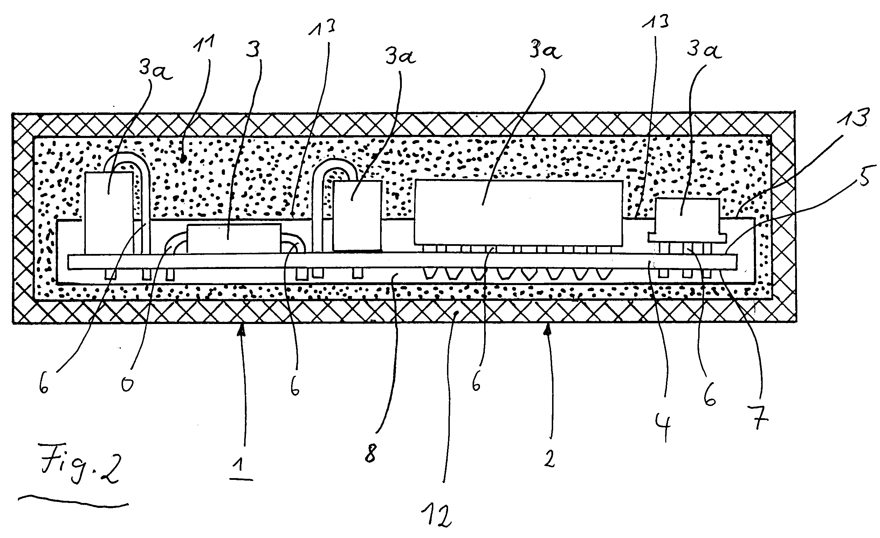

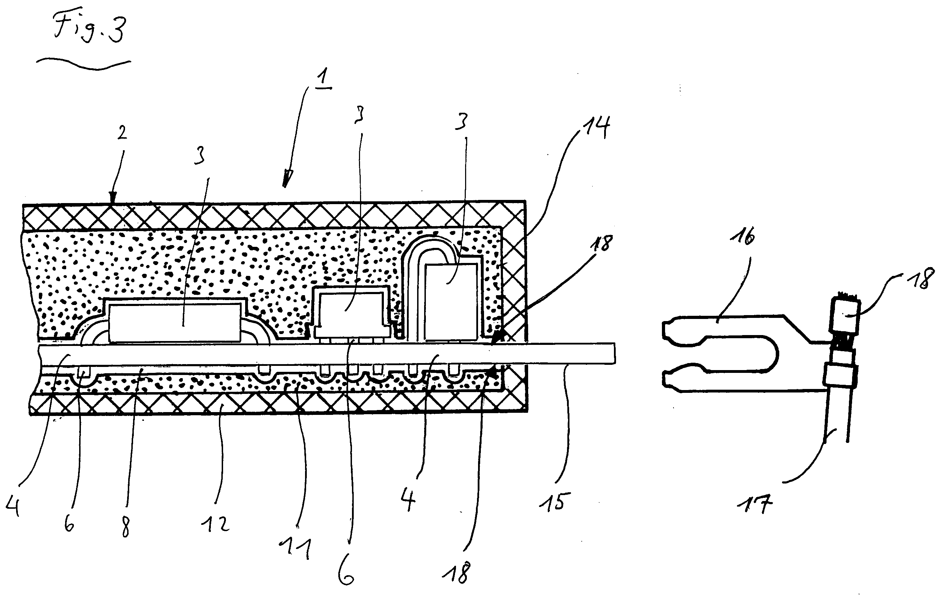

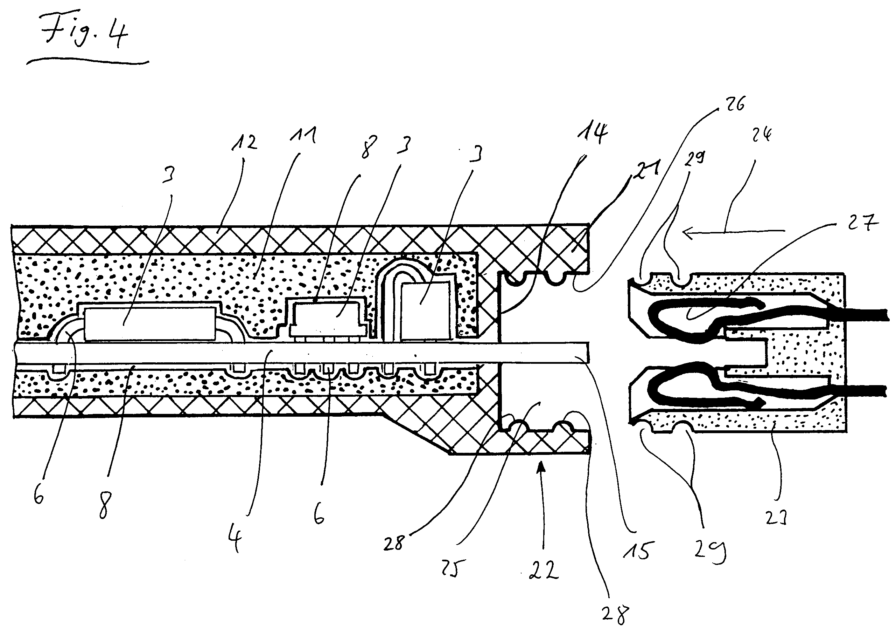

Wie insbesondere aus Fig.1 hervorgeht, setzt sich das erfindungsgemäße Steuergerät, das insgesamt mit dem Bezugszeichen 1 bezeichnet ist, aus einem Formkörper 2 und einer mit elektrischen und/oder elektronischen Bauelementen 3 bestückten Leiterplatte 4 zusammen. Die Leiterplatte 4 ist innerhalb des Formkörpers 2 angeordnet und von diesem vollständig umschlossen.

Die Leiterplatte 4 ist in herkömmlicher Weise aufgebaut. Die Bauelemente 3 sind auf der Bestückungsseite 5 der Leiterplatte angeordnet und dort mit ihren Kontaktfüßchen 6 in entsprechenden Bohrungen der Leiterplatte eingesteckt. Die Kontaktfüßchen stehen aus der der Bestückungsseite 5 abgewandten Lötseite 7 der Leiterplatte hervor und sind dort mit der Leiterplatte verlötet.

Der Formkörper 2 ist von etwa quaderförmiger Gestalt und ist aus insgesamt drei Schichten mit unterschiedlicher Elastizität, Härte und Konsistenz aufgebaut. Alle drei Schichten bestehen aber aus dem gleichen Werkstoff, nämlich Polyurethan, im folgenden mit PUR bezeichnet. Die innerste Schicht des Formkörpers umgibt die Leiterplatte 4 samt ihren Bauelementen 3 in einer relativ dünnen Schicht. Diese Schicht bildet eine Grundisolierung 8 der Leiterplatte 4. Die Grundisolierung, die die Leiterplatte nach Art eines Außenskeletts umgibt, erfüllt folgende Funktionen: Sie dichtet zum einen die Leiterplatte 4 und die darauf angeordneten Bauelemente 3 hermetisch gegenüber Feuchtigkeit und anderen korrodierenden Einflüssen ab. Die zweite Funktion der Grundisolierung 8 besteht darin, die Bauelemente 3 nach Art eines Korsetts abzustützen und zu fixieren, d.h. also, die Einwirkung von Stößen, Beschleunigungskräften und Vibrationen zu mildern. Bekanntlich sind die Kontaktfüßchen von elektronischen oder auch elektrischen Bauteilen aus Gründen der Gewichts- und Materialeinsparung nur relativ dünn ausgebildet. Durch fortgesetzte Vibrationen und etwa negativen Beschleunigungskräften beim Abbremsen eines Kraftfahrzeuges besteht die Gefahr der Beschädigung dieser insgesamt nicht sehr stabilen Kontaktfüßchen. Durch die genannte Grundisolierung ist diese Gefahr deutlich reduziert. Eine dritte Funktion der Grundisolierung 8 besteht schließlich darin, daß sie die Bauelemente 3 zumindest in gewissem Maße vor Wärmeeinwirkung schützt.

Das PUR-Material für die Grundisolierung 8 weist eine relativ hohe Elastizität und eine dementsprechend geringere Härte und Festigkeit auf. Bekanntlich können diese Parameter bei PUR-Material in weiten Grenzen eingestellt werden. Es müssen nur entsprechende Ausgangskomponenten und Mischungsverhältnisse gewählt werden. Da die genaue Zusammensetzung des verwendeten PUR-Materials nicht der Kern der vorliegenden Erfindung ist und weil die gewünschten mechanischen Eigenschaften durch Additive in hohem Maße beeinfluß - und variierbar sind, soll und kann eine genaue Zusammensetzung des Polyurethans nicht angegeben werden. Für die Grundisolierung 8 ist es jedenfalls anzustreben, daß nach dem Aushärten das Material noch relativ elastisch ist. Dadurch wird insbesondere der Vibrationsschutz für die Bauelemente 3 gewährleistet. Je nach Größe und Masse der Bauteile kann es erforderlich sein, die Elastizität und dementsprechend die Härte und Festigkeit der Grundisolierung 8 zu verändern. In welchem Maße dies zu geschehen hat, hängt von den jeweiligen Gegebenheiten ab und muß ggf. im Einzelfall empirisch ermittelt werden.

Ein bei einem bevorzugten Ausführungsbeispiel verwendetes Material besteht aus einem modifizierten Polyurethanharz, das im ausgehärteten Zustand transparent und relativ weich ist. Das Material muß jedoch nicht unbedingt transparent sein. Die Transparenz hat allerdings den Vorteil, daß nach dem Aufbringen der Grundisolierung auf die Bestückungsseite der Leiterplatte 4 evtl. Lufteinschlüsse oder eine unvollständige Haftung des Materials an der Leiterplattenoberfläche erkannt werden können. Bei der Herstellung der Grundisolierung 8 wird so vorgegangen, daß die Grund- und die Vernetzungskomponente des Polyurethanharzes im Moment des Aufbringens auf die Leiterplatte mit Hilfe von möglichen Mischköpfen zusammengemischt werden. Das Aufbringen selbst kann entweder ein Sprüh- oder ein Gießvorgang sein. Wenn die Ausgangsmischung auf die Leiterplatte 4 aufgegossen wird, kann es vorteilhaft sein, wenn die Leiterplatte in einem offenen Formkasten einliegt. Bei der Aushärtung des PUR-Materials werden im Gegensatz zu beispielsweise Epoxy- und Polyesterharzen nur Temperaturen von nicht mehr als etwa 50° C erreicht. Es eignet sich deshalb besonders gut für wärmeempfindliche Bauelemente 3. Die in Rede stehende Ausgangsmischung enthält im wesentlichen als Grundkomponente ein Polyol und als Vernetzungskomponente ein Isocianat, die im Verhältnis 4:1 miteinander gemischt werden. Nach dem Aushärten weist das Material folgende Eigenschaften auf:

| | |
|---|---|
| Dichte bei 20°C (g/ccm): | 0,96 |
| Anfangsviskosität der Ausgangsmischung bei 20°C (mPas) | 2000 |
| Shore-Härte A | 25,0 |
| Zugfestigkeit (N/mm²): | 4,4 |
| Reißdehnung (%): | 270,00 |
| 100%-Modul (N/mm²): | 2,5 |
| Reißfestigkeit (N/mm²): | 6,8 |

Die im wesentlichen vollständig von der Grundisolierung 8 eingehüllte Leiterplatte 4 ist weiterhin von einer zweiten Schicht, nämlich einer Stützschicht 11 umgeben. Die Leiterplatte 4 ist mit ihren Bauelementen 3 in dieser Stützschicht eingebettet. Die Stützschicht ist vorzugsweise so ausgeformt, daß sie bereits der endgültigen Form des Steuergeräts entspricht. Ihre Hauptfunktion besteht in dem mechanischen Schutz der Bauelemente 3 vor allem vor stärkeren Erschütterungen und Beschleunigungskräften. Aufgrund ihrer trägen Masse wirken auf die elektronischen Bauteile bei Erschütterungen und beim Abbremsen des Fahrzeugs sowohl parallel als auch quer zur Planfläche der Leiterplatte gerichtete Kräfte. Ohne die Stützschicht 11 bestünde die Gefahr, daß die elektrische und mechanische Verbindung zwischen den Bauelementen und der Leiterplatte beschädigt werden könnte. Daneben hat die Stützschicht 11 noch die Aufgabe, die Bauelemente 3 vor Feuchtigkeit und Wärmeeinwirkung zu schützen. Letzteres ist insbesondere dann von Bedeutung, wenn Steuergeräte in nächster Nähe eines Kraftfahrzeugmotors oder einer sonstigen Wärmequelle montiert werden müssen. Durch das Zusammenspiel der Stützschicht 11 und der Grundisolierung 8 sind die Bauelemente 3 in hohem Maße gegen die Auswirkungen von Vibrationen und Beschleunigungskräften geschützt. Die Auswirkungen sind in beiden Fällen, daß sich die Bauelemente 3 von der Leiterplatte lösen, sei es, daß die Kontaktfüßchen 6 aus ihrer Verlötung gerissen oder abgeschert werden.

Zum Aufbringen der Stützschicht 11 wird die bereits mit einer Grundisolierung versehene Leiterplatte 4 in einer entsprechend bemessenen Form angeordnet und die Form mit einem PUR-Material ausgegossen.

Auf die genannte Art und Weise wurden Steuergeräte unter Verwendung eines Zweikomponenten-Polyurethans hergestellt. Die Ausgangsmaterialien, Polyol und Isocyanat wurden im Verhältnis von 10:1 miteinander gemischt. Nach dem Aushärten, beispielsweise nach einer Topfzeit von 15 Minuten bei Umgebungstemperatur, wird eine Stützschicht 11 erhalten, die folgende mechanische Eigenschaften aufweist:

| | |
|---|---|
| Viskosität der Ausgangsmischung bei 25°C (mPas) | 8500 |
| Dichte (Gramm/ccm): | 1,5 |
| Shore-Härte A: | 45 |
| Zugfestigkeit (N/mm²): | 1,143 |
| Bruchdehnung (%) | 207 |
| Durchschlagsfestigkeit 50 Hz bei 20°C (kV/mm) | 25 |
| Wärmeleitfähigkeit (W/mK): | 0,6 |

Auch dieses Material erwärmt sich beim Aushärten nur geringfügig. Die Beschleunigung der Aushärtung kann durch eine Erhöhung der Außentemperatur beschleunigt werden. In einem solchen Fall sind evtl. vorhandene sehr wärmeempfindliche Bauelemente durch die bereits vorhandene wärmeisolierende Grundisolierung 8 geschützt.

Neben dem oben beschriebenen Vollmaterial kann als Stützschicht 11 auch ein Schaumstoff verwendet werden. In diesem Falle ist den Ausgangskomponenten ein Schaumbildner beigefügt. Die Grundkomponente Polyol und die Vernetzungskomponente Isocyanat werden im Verhältnis 2:1 gemischt. Nach dem Aushärten ergibt sich ein Schaum mit den folgenden Eigenschaften:

| | |
|---|---|
| Dichte (g/ccm): | 0,25 |
| Shore-Härte A: | 23 |
| Zugfestigkeit (KPa): | 700 |
| Bruchdehnung (%): | 150 |
| Weiterreißfestigkeit n DIN 53507 (N/mm²): | 2 |
| Stauchhärte, 40%-Kompression,n DIN 53577 (KPa): | 75 |

Den äußeren Abschluß des Steuergerätes 1 bildet schließlich eine Außenschicht 12, die ebenfalls aus PUR besteht. Die Außenschicht 12 weist aber gegenüber der Stützschicht 11 eine größere Härte und Festigkeit auf. Sie dient als mechanischer Schutz und soll beispielsweise das Eindringen von spitzen Gegenständen, etwa bei der Reparatur eines Kraftfahrzeuges verhindern. Das Material ist ggf. durch Zusatz entsprechender Additive resistent gegenüber den in einem Kraftfahrzeug verwendeten Betriebsflüssigkeiten, wie Motor- und Getriebeöl, Bremsflüssigkeit etc. eingestellt. Sie ist außerdem bis mind. 150°C hitzebeständig.

Die Außenschicht 12 wird durch Zusammenmischen der bereits schon erwähnten Komponenten Polyol und Isocyanat im Verhältnis 100:28 erhalten. Dazu wird die von der Stützschicht 11 umgebene Leiterplatte in eine entsprechend bemessene Form eingelegt und mit dem zunächst flüssigen Ausgangsmaterial ausgegossen. Der Abstand der Oberfläche der Stützschicht 11 von der Forminnenwandung ist dabei so bemessen, daß die Außenschicht eine für ihre gewünschte Schutzfunktion ausreichende Dicke erhält. Nach dem Aushärten und Entformen wird eine Außenschicht erhalten, die folgende Eigenschaften aufweist:

| | |
|---|---|
| Dichte (g/ccm): | 1,47 |
| Viskosität der Ausgangsmischung bei 25°C (mPas): | 6000 |
| Shore-Härte D: | 82 |
| Zugfestigkeit (N/mm²): | 43 |
| Bruchdehnung (%): | 4 |
| Biegefestigkeit (N/mm²): | 69 |
| Durchschlagsfestigkeit 50 Hz bei 20 °C (kV/mm): | 36 |
| Oberflächenwiderstand (Ohm): | 2x10¹⁴ |
| Wärmeleitfähigkeit (W/mK): | 0,6 |

In Fig.2 ist ein Ausführungsbeispiel dargestellt, bei dem die die Grundisolierung 8 bildende Schicht eine wesentlich größere Dicke aufweist als jene in dem Ausführungsbeispiel der Fig.1. Die Grundisolierung 8 ist hier etwa quaderförmig ausgebildet. Sie weist eine solche Dicke auf, daß die Bauelemente 3a mit größerer Bauhöhe aus der Oberseite 13 der Grundisolierung 8 herausragen. Der aus der Grundisolierung 8 herausragende Teil der Bauelemente 3a ist von der Stützschicht 11 umgeben. Durch die in Fig.2 dargestellte Ausgestaltung der Grundisolierung kann ihre Schutzwirkung gegenüber Vibrationen erhöht werden.

In Fig.3 ist ein Ausführungsbeispiel gezeigt, bei dem die Leiterplatte 4 aus der einen Schmalseitenwand 14 des Steuergerätes 1 herausragt. Der herausragende und zur Kontaktierung mit etwa einem Anschlußkabel dienende Kontaktbereich 15 der Leiterplatte 4 ist mit (nicht dargestellten) Kontaktflächen versehen, die über Leiterbahnen mit dem innerhalb der Außenschicht 12 angeordneten Bereich der Leiterplatte verbunden sind. Auf den Kontaktbereich 15 ist zur elektrischen Kontaktierung ein Klemmkontakt 16 aufschiebbar. Mit dem Klemmkontakt 16 ist über eine Krimpverbindung 19 ein Anschlußkabel 17 verbunden. Der Vorteil dieser Ausgestaltung liegt vor allen Dingen darin, daß zur Herstellung des Kontaktes zwischen einem Anschlußkabel 17 und der Leiterplatte 4 keine nachträglichen bzw. zusätzlichen Montagearbeiten für das Anbringen eines Verbindungselements, etwa eines Steckers, notwendig sind. An einem solchen nachträglich angebrachten Stecker müßten außerdem aufwendige Abdichtungsmaßnahmen ergriffen werden. Solche zusätzlichen Montagearbeiten könnten durch die vorgeschlagene Ausgestaltung vermieden werden. Die für die Herstellung des Steuergeräts verwendeten Formen weisen eine Abmessung auf derart, daß die Leiterplatte an einer Seite aus den nacheinander auf die Leiterplatte aufgebrachten Schichten herausragt. Eine zusätzliche Abdichtung des herausgeführten Leiterplattenteils 15 ist nicht notwendig, da eine Abdichtung im Durchtrittsbereich 18 der Leiterplatte 4 sowohl durch die Grundisolierung 8 als auch durch die Außenschicht 11 gewährleistet ist.

Bei dem in Fig. 4 dargestellten Ausführungsbeispiel ist der Kontaktbereich 15 der Leiterplatte 4 von einem vom Rand der Schmalseitenwand 14 vorstehenden Kragen 21 umgeben. Durch den an die Außenschicht 12 angeformten Kragen 21 ist an der Schmalseitenwand 14 ein Steckergehäuse 22 gebildet derart, daß damit eine Buchse 23 verbindbar ist. Ausgehend von der in Fig. 4 dargestellten Situation ist die Buchse 23 durch Bewegung in Einsteckrichtung 24 in den Steckerinnenraum 25 einführbar. Die Innenwand 26 des Steckergehäuses 22 verläuft parallel zur Einsteckrichtung 24 bzw. parallel zur Planfläche der Leiterplatte 4. Auf der Bestückungsseite 5 und der Lötseite 7 des in den Buchsenraum 25 hineinragenden Kontaktbereichs 15 sind (nicht dargestellt) Kontaktflächen vorhanden. Diese Kontaktflächen wirken mit den in der Buchse 23 angeordneten Klemmkontakten 27 im Sinne einer elektrischen Verbindung zusammen. An der Innenwand 26 des Steckergehäuses 22 sind zwei parallel zueinander und rechtwinklig zur Einsteckrichtung 24 verlaufende umlaufende Dichtlippen 28 angeordnet. Im Kontaktzustand greifen diese Dichtlippen in entsprechend angeordnete komplemäntere Ausnehmungen 29 in der Außenfläche der Buchse 23 ein. Auf diese Weise wird der Zutritt von Feuchtigkeit über die von der Außenfläche der Buchse 23 und der Innenwand 26 des Steckergehäuses 22 gebildete Trennfuge verhindert.

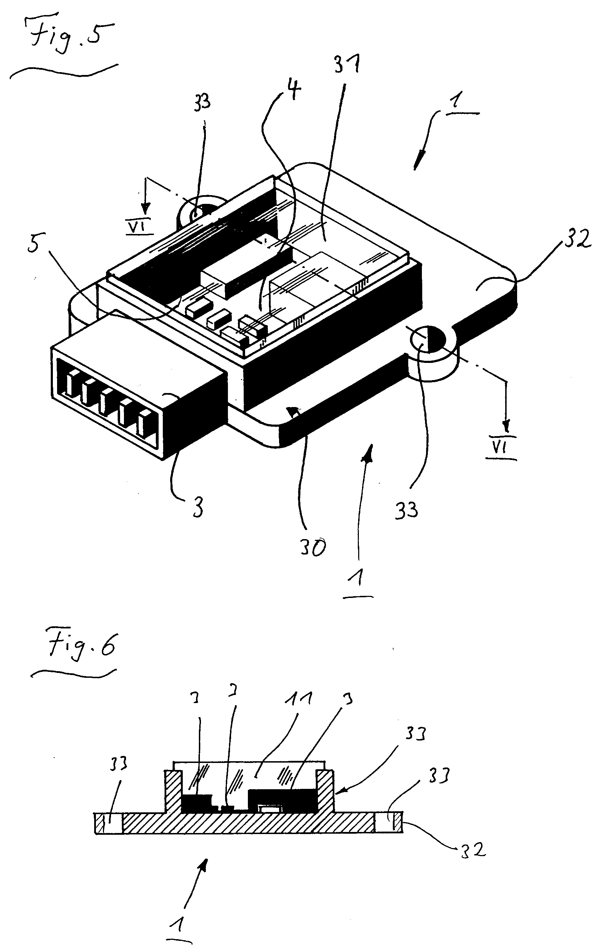

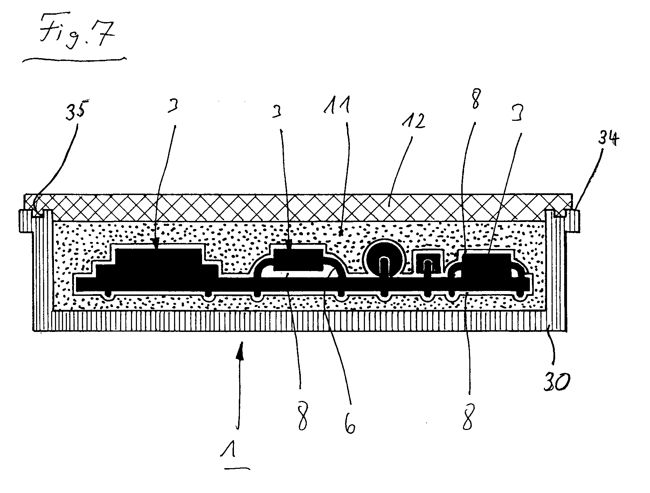

In Fig. 5 ist ein Ausführungsbeispiel eines erfindungsgemäßen Steuergeräts dargestellt, bei dem die mit Bauelementen 3 bestückte Leiterplatte 4 in einer herkömmlichen Gehäuseschale 30 angeordnet ist. Die Leiterplatte 4 ist, wie oben beschrieben, mit einer Grundisolierung 8 versehen. Diese Grundisolierung 8 ist sowohl auf der Bestückungsseite 5 als auch auf der Lötseite 7 der Leiterplatte 4 vorhanden. Die Leiterplatte 4 füllt praktisch vollständig die Querschnittsfläche des Innenraums 31 der Gehäuseschale 30 aus. Die Gehäuseschale 30 wird nun nicht, wie bisher üblich, mit einem Deckel verschlossen und durch Anordnen eines Dichtringes zwischen Deckel und Gehäuseschale 30 abgedichtet. Der Innenraum 31 der Gehäuseschale 30 ist vielmehr vollständig mit der oben beschriebenen Stützschicht 11 ausgefüllt. Wie aus Fig.5 und 6 ersichtlich ist, ist noch keine abschließende Außenschicht 12 auf die Stützschicht 11 aufgebracht. Dies geschieht erst in einem nachfolgenden Schritt. Es ist jedoch auch denkbar, diese Außenschicht 12 völlig weg zu lassen. Dies könnte beispielsweise dann zweckmäßig sein, wenn das Steuergerät an einem geschützten Ort eines Kraftfahrzeuges angebracht werden soll. In dem in Fig. 5 gezeigten Beispiel ist für die Herstellung der Stützschicht 11 ein durchsichtiges PUR-Material verwendet worden. Die Leiterplatte 4 und die sich darauf befindlichen Bauelemente 3 sind deshalb von außen sichtbar. An der Gehäuseschale 30 ist ein Stecker 36 zur Kontaktierung des Steuergeräts mit einem Anschlußkabel angebracht. Die Gehäuseschale 30 weist außerdem eine flanschartige Verbreiterung 32 auf, die mit zwei Befestigungsaugen 33 versehen ist. Eine derartige flanschartige Verbreiterung 32 mit Befestigungsaugen 33 ist auch bei den in den Fig.1-4 dargestellten Ausführungsbeispielen denkbar. Dazu müßte nur die zur Herstellung der Außenschicht 12 verwendete Form entsprechend ausgestaltet sein.

In Fig.7 ist ein Steuergerät dargestellt, das bereits fertiggestellt ist, es enthält nämlich eine abschließende Außenschicht 12. Wie aus Fig. 7 ebenfalls ersichtlich ist, weist die Gehäuseschale 30 auf ihrem Öffnungsrand 34 eine umlaufende Nut 35 auf. Diese Nut 35 ist ursprünglich zum Einlegen eines Dichtringes vorgesehen, um eine Abdichtung zwischen einem Deckel und dem Gehäuseinnenraum zu erzielen. Der Deckel wird aber im vorliegenden Fall durch die Außenschicht 12 ersetzt, die sich zumindest so weit über den Öffnungsrand 34 erstreckt, daß die Nut 35 abgedeckt ist. Bei der Herstellung der Außenschicht 12 läuft die Ausgangsmischung in die Nut 35 hinein. Nach dem Aushärten entsteht somit zwischen der Außenschicht 12 und dem Öffnungsrand 34 sowohl eine stoff- als auch eine formschlüssige Verbindung. Die Stabilität der aus Außenschicht 12 und Gehäuseschale 30 bestehenden Außenhaut des Steuergeräts wird dadurch erhöht. Die Verbindung zwischen der Außenschicht 12, also quasi dem Deckel des Gehäuses, hält auch bei einem etwa durch Wärme- oder chemische Einwirkung hervorgerufenen Verzug der Gehäuseschale 30 stand.

### Bezugszeichenliste

- 1: Steuergerät
- 2: Formkörper
- 3: Bauelement
- 4: Leiterplatte
- 5: Bestückungsseite
- 6: Kontaktfüßchen
- 7: Lötseite
- 8: Grundisolierung
- 11: Stützschicht
- 12: Außenschicht
- 13: Oberseite
- 14: Schmalseitenwand
- 15: Kontaktbereich
- 16: Klemmkontakt
- 17: Anschlußkabel
- 18: Durchtrittsbereich
- 19: Krimpverbindung
- 21: Kragen
- 22: Steckergehäuse
- 23: Buchse
- 24: Einsteckrichtung
- 25: Buchseninnenraum
- 26: Innenwand
- 27: Klemmkontakt
- 28: Dichtlippen
- 29: Ausnehmungen
- 30: Gehäuseschale
- 31: Innenraum
- 32: Verbreiterung
- 33: Befestigungsauge
- 34: Öffnungsrand
- 35: Nut
- 36: Stecker

## Patentansprüche

1. Elektrisches Steuergerät, insbesondere für Kraftfahrzeuge, mit einer als Träger der elektrischen Schaltung dienenden Leiterplatte (4), die wenigstens auf einer Seite mit elektrischen bzw. elektronischen Bauelementen (3) bestückt ist,
dadurch gekennzeichnet,
daß die Leiterplatte (4) zumindest auf ihrer Bestückungsseite (5) mit wenigstens drei Schichten aus dem gleichen Kunststoffmaterial abgedeckt ist und die einzelnen Schichten unterschiedliche mechanische Eigenschaften, wie Elastizität und Härte aufweisen, wobei
- die erste Schicht eine Grundisolierung ist, die zumindest den bestückten Bereich der Leiterplatte unter zumindest teilweiser Umhüllung der elektronischen Bauelemente (3) abdeckt,
- die zweite Schicht sich an die Grundisolierung (8) als eine Stützschicht (11) anschließt, die zumindest den bestückten und mit der Grundisolierung (8) versehenen Bereich der Leiterplatte (4) abdeckt und dabei die elektronischen Bauteile (3) vollständig in sich einschließt, und
- die dritte Schicht sich an die Stützschicht (11) als eine Außenschicht (12) anschließt, die zumindest den von der Stützschicht (11) überdeckten Bereich der Leiterplatte (4) nach Art einer Gehäuseschale oder eines Gehäusedeckels abschließt und die eine höhere Festigkeit und Härte aufweist als die Grundisolierung (8) und die Stützschicht (11).

2. Steuergerät nach Anspruch 1,
dadurch gekennzeichnet,
daß das Kunststoffmaterial in Form einer aus zwei unter Aushärtung miteinander reagierenden flüssigen Komponenten, nämlich einer Grundkomponente und einer Vernetzungskomponente, bei Raumtemperatur auf der Leiterplatte (4) ausgebracht ist.

3. Steuergerät nach Anspruch 2,
dadurch gekennzeichnet,
daß die Grundkomponente wenigstens ein Polyol und die Vernetzungskomponente ein Isocyanat enthält.

4. Steuergerät nach einem der Ansprüche 1-3,
dadurch gekennzeichnet,
daß die Außenschicht (12) und die Grundisolierung (8) aus einem Vollmaterial bestehen.

5. Steuergerät nach Anspruch 4,
dadurch gekennzeichnet,
daß die Stützschicht aus einem Vollmaterial besteht.

6. Steuergerät nach Anspruch 4,
dadurch gekennzeichnet,
daß die Stützschicht (11) aus einem Schaummaterial besteht.

7. Steuergerät nach einem der Ansprüche 1-6,
dadurch gekennzeichnet,
daß die Grundisolierung auch auf der nicht mit elektronischen Bauelementen bestückten Lötseite (7) der Leiterplatte (4) vorhanden ist.

8. Steuergerät nach einem der Ansprüche 1-7,
dadurch gekennzeichnet,
daß die Leiterplatte (4) in einer Gehäuseschale (30) angeordnet und der die Leiterplatte (4) umgebende Innenraum der Gehäuseschale mit der Stützschicht (11) vorzugsweise unter vollständigem Einschluß der Leiterplatte und ihrer Bauelemente ausgefüllt ist.

9. Steuergerät nach Anspruch 8,
dadurch gekennzeichnet,
daß die Außenschicht (12) so angeordnet ist, daß sie die Öffnung der Gehäuseschale (30) vollständig überdeckt.

10. Steuergerät nach Anspruch 9,
dadurch gekennzeichnet,
daß die Außenschicht (12) den Öffnungsrand der Gehäuseschale (30) zumindest teilweise überdeckt und damit stoffschlüssig verbunden ist.

11. Steuergerät nach Anspruch 10,
dadurch gekennzeichnet,
daß der Öffnungsrand (34) der Gehäuseschale (30) eine umlaufende Nut aufweist, die von der Außenschicht (12) ausgefüllt ist.

12. Steuergerät nach einem der Ansprüche 1-7,
dadurch gekennzeichnet,
daß die Leiterplatte (4) mit ihrer Grundisolierung (8) vollständig von der Stützschicht (11) umgeben und darin eingebettet und die Stützschicht ihrerseits vollständig von der Außenschicht 12 nach Art eines Gehäuses umgeben ist.

13. Steuergerät nach Anspruch 12,
dadurch gekennzeichnet,
daß zur Verbindung des Steuergeräts mit einem Anschlußkabel (17) an die Außenschicht (12) ein Steckergehäuse (22) angeformt ist.

14. Steuergerät nach Anspruch 13,
dadurch gekennzeichnet,
daß die Leiterplatte (4) durch die Außenschicht (12) hindurch mit einem Kontaktelemente tragenden Kontaktbereich (15) in den Innenraum des Steckergehäuses (22) hineinragt.
